# EUROPEAN PATENT APPLICATION

(11) **EP 0 986 293 A1**
(43) Date of publication of application: **15.03.2000**
(21) Application number: 98307227.3
(22) Date of filing: 08.09.1998
(51) Int. Cl.: H05K 9/00

(54) **Radio frequency electronic apparatus**

(71) Applicant: Lucent Technologies Inc., Murray Hill, New Jersey 07974 (US)
(72) Inventor: Falaki, Hamid Reza, Peatmoor, Swindon, Wiltshire SN5 5A (GB); Sparkes, Stephen, Farnborough GU1 40HX (GB); Thompson, Brian John, Reading RG2 8QR (GB)
(74) Representative: Johnston, Kenneth Graham

(57) **Abstract**

Electronic apparatus has modules operating at radio frequencies. The modules comprise components operatively mounted on a common circuit board contained by a conductive case which is subdivided by internal partition walls separating modules one from another. The partition walls extend from a base at an outer wall of the case to an apex adjacent the circuit board. The apex is sealed to the circuit board by a deposited compressible conductive gasket. The thickness of a circuit board is subject to wide tolerance, for example 10% in the case of multilayer circuit board. The gasket allows the screen to be carried right to the board so that electrical contact can be obtained between an earth track on the board and the partition wall of the case.

## Description

This invention relates to electronic apparatus operating at radio frequencies.

When apparatus is operative at radio frequencies it is often necessary to screen it against radio frequency emissions, both as a whole and to screen one module of the apparatus from another. Ineffective screening can lead to feedback and interference problems.

Against this background, there is provided electronic apparatus having modules operating at radio frequencies, said modules comprising components operatively mounted on a common circuit board contained by a conductive case which is subdivided by internal partition walls separating modules one from another, the partition walls extending from a base at an outer wall of the case to an apex adjacent the circuit board, the apex being sealed to the circuit board by a deposited compressible conductive gasket. The thickness of a circuit board is subject to wide tolerance, for example 10% in the case of multilayer circuit board. The gasket allows the screen to be carried right to the board so that electrical contact can be obtained between a track on the board and the partition wall of the case.

Preferably, the gasket is deposited on the apex of the partition walls.

In one embodiment the internal partition walls extend from opposite outer walls of the case towards opposite sides of the circuit board.

Most preferably the peripheral walls are stepped complimentarily in transverse cross section to provide pairs of opposed surfaces at two levels, one pair of the surfaces being in direct contact with each other, the other pair extending to opposed sides of the circuit board and at least one having a compressible conductive gasket deposited thereon. This allows the surfaces in direct contact to operate as a dead stop, preventing the gasket from being over tightened.

One embodiment of the invention will now be described, by way of example, with reference to the accompanying drawings, in which:
Figure 1 is an exploded pictorial view of a transmit receive unit embodying the invention;
Figure 2a is a section along the line P-P of the assembled unit of Figure 1 in the direction of the arrows;
Figure 2b is a transverse cross section through a peripheral wall of the case of the unit of Figure 1;
Figure 3 is a plan view of a power amplifier embodying the invention; and
Figure 4 is a section on arrows Q-Q of Figure 3.

Referring to the drawings, a transmit receive unit is constructed on a two sided multilayer circuit board 2 which is contained by an aluminium case constructed in two parts 4,6. The case acts as a RF (radio frequency) screen. The components of two transmitters and two receivers are mounted on the board 2. Base band data to be transmitted and data received are input and output on multipin connectors 8 and 10. Radio frequency signals received by antennas (not shown) are input via a duplexer on co-axial sockets 12 and 14. Radio frequency signals to be transmitted by the antennas are output from co-axial sockets 16 and 18 to power amplifiers (not shown).

The components are mounted on both sides of the board and are arranged in a number of sub-modules. Each module is required to be RF screened from the others to prevent feedback and interference problems.

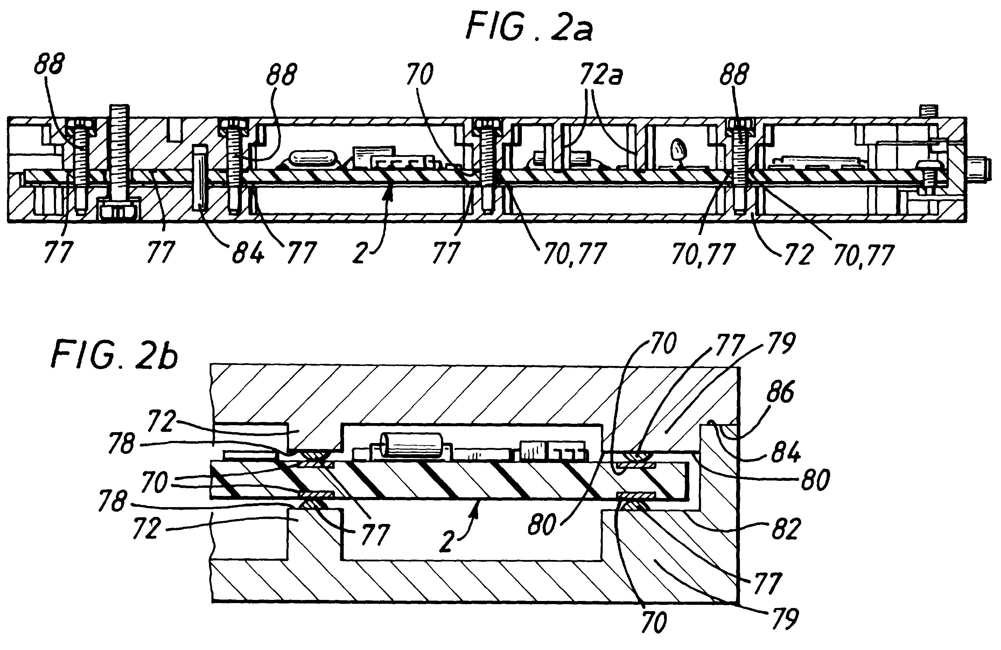

On the circuit board each module is surrounded by an earth track 70. The components of each module are contained by internal partition walls 72 which are formed integrally with the walls 76 of the casing and which extend from a base 74 at an outer wall 76 of the part 4 or 6 of the cover, to an apex 78. Similar walls extend from both parts 4 and 6 of the case, see Figure 2. Most partition walls 72 have a complimentary wall extending from the opposite part 4 or 6 of the case. The board is thus supported between the walls 72. In some cases, partition walls 72a extend from only one part 6 of the case.

Especially because the circuit board is multi layer, the tolerance on its thickness is significant: about 10%. This amounts to about 0.3 mm variation in thickness. It is thus not possible to clamp both partition walls up directly on the circuit board.

As may be seen from Figure 2b, peripheral walls 78 of the case are complimentarily stepped in transverse cross section. A pair of opposed faces 80 and 82 extend to opposite sides of the circuit board 2 similarly to the partition walls 72. Another pair of opposed faces 84 and 86, at a different level from the faces 80 and 82, are in direct contact with each other thus acting as a dead stop.

In order to accommodate the variations in the thickness of the circuit board, a compressible conductive gasket material 77 in the form of a silicone base filled with conductive particles is deposited on the apex 78 of the partition walls and the faces 80,82 extending from the lower part 4 of the case. A suitable gasket material is available from Altoflex S.A. 38 Rue des Maraichers, F75929 Paris, France under the trade name Altocad SNL 55. The material has a resistivity of 0.008 ohm cm, a hardness of 57, elongation at break 105%, adhesion on aluminium >10 N/cm², density 2.1 g/cm³ and a temperature range of -50°C to +125°C. Cure is catalysed by humidity.

In some applications the gasket material may be applied to all partition walls and both faces 80 and 82. The material is applied by a computer numerically controlled (CNC) nozzle, both the position and diameter of the nozzle being computer controlled.

The circuit board 2 is located in the part 4 of the case by pins 84 which also locate the two halves of the case. The parts 4 and 6 of the case are held together by screws 88 extending through holes 89 in the board and through holes 90 incorporated in the partition walls 72 and in the stepped peripheral walls 79.

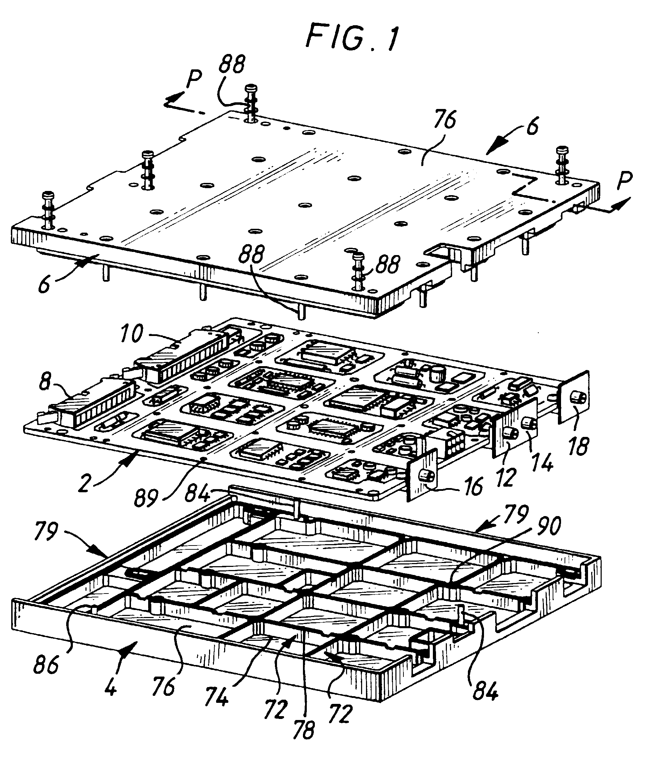

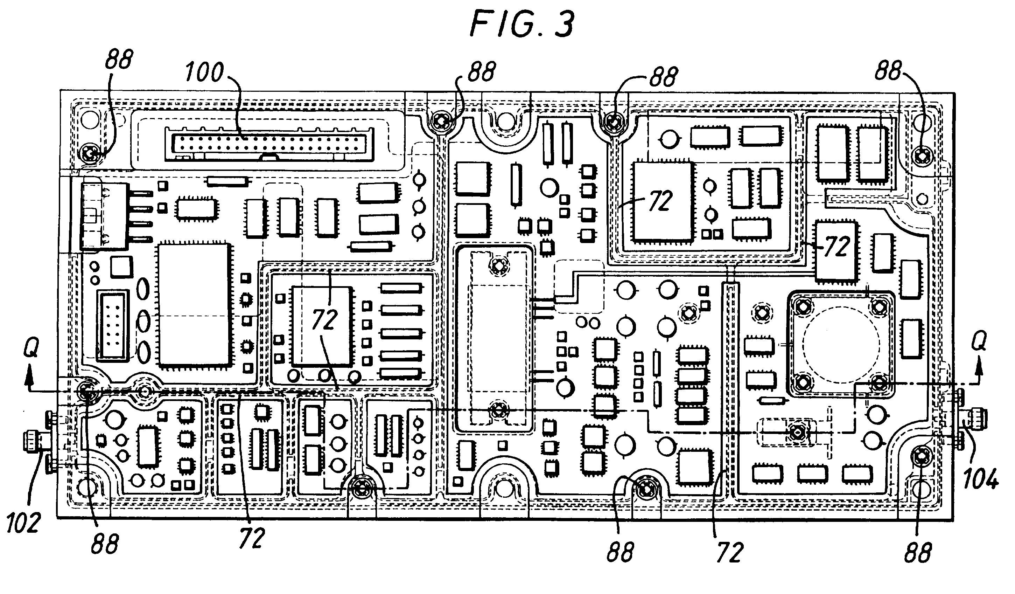

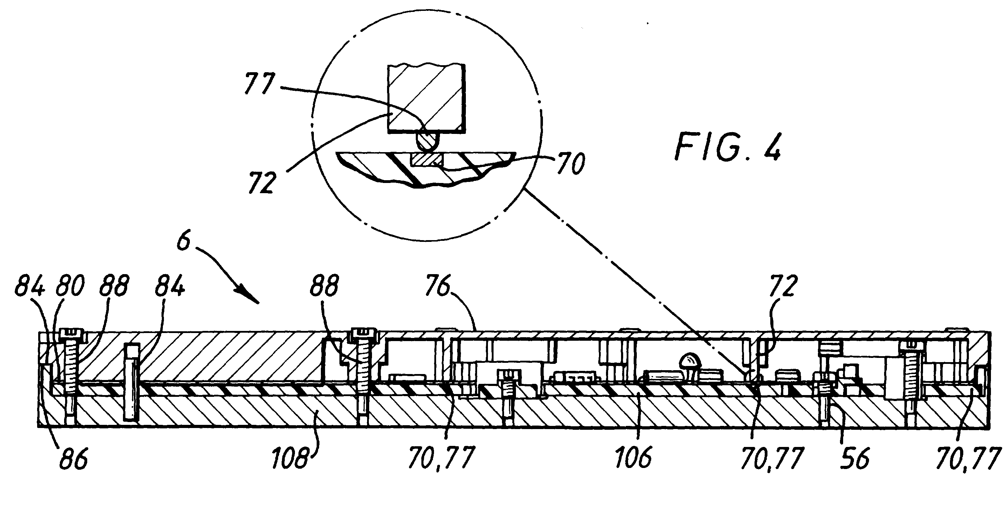

In the power amplifier shown in Figures 3 and 4, features which correspond with those of Figures 1, 2a and 2b are given corresponding reference numbers. The amplifier has a multipin connector 100 by which control data is received. Radio frequency input signals are received at a co-axial connector 102 from one output 16 or 18 of the transmit receive unit shown in Figures 1, 2a and 2b. Power output to the antenna is taken from a co-axial connector 104.

The circuit board 106 is multilayer, but in this example has components mounted on one side only. The other side is in direct heat conducting contact with the lower part 108 of the case. On the circuit board, the components are grouped in separate modules. An earth track surrounds each module on the board. The modules are RF isolated by partition walls 72 on the apex of which compressible conductive gasket material is deposited.

## Claims

1. Electronic apparatus having modules operating at radio frequencies, said modules comprising components operatively mounted on a common circuit board contained by a conductive case which is subdivided by internal partition walls separating modules one from another, the partition walls extending from a base at an outer wall of the case to an apex adjacent the circuit board, the apex being sealed to the circuit board by a deposited compressible conductive gasket.

2. Electronic apparatus as claimed in claim 1, wherein the gasket is deposited on the apex.

3. Electronic apparatus as claimed in claim 2, wherein internal partition walls extend from opposite outer walls of the case towards opposite sides of the circuit board.

4. Electronic apparatus as claimed in any preceding claim, having peripheral walls which are stepped complimentarily in transverse cross section to provide pairs of opposed surfaces at two levels, one pair of the surfaces being in direct contact with each other, the other pair extending to opposed sides of the circuit board and at least one having a compressible conductive gasket deposited thereon.
